Europäisches Patentamt

European Patent Office

Office européen des brevets

(19)

(11) Publication number: **0 155 324 B1**

(12) **EUROPEAN PATENT SPECIFICATION**

(45) Date of publication of patent specification: **20.01.93**    (51) Int. Cl.5: **G01R 33/04**

(21) Application number: **84903365.9**

(22) Date of filing: **10.09.84**

(86) International application number:
**PCT/JP84/00432**

(87) International publication number:
**WO 85/01357 (28.03.85 85/08)**

(54) **APPARATUS FOR DETECTING MAGNETISM.**

(30) Priority: **09.09.83 JP 166080/83**
**09.09.83 JP 166081/83**
**26.12.83 JP 247216/83**
**26.12.83 JP 247217/83**

(43) Date of publication of application:
**25.09.85 Bulletin  85/39**

(45) Publication of the grant of the patent:
**20.01.93 Bulletin  93/03**

(84) Designated Contracting States:
**DE FR GB**

(56) References cited:
**GB-A- 1 067 791**
**US-A- 3 005 158**
**US-A- 3 883 826**
**US-A- 4 300 095**

(73) Proprietor: **MISHIMA KOSAN CO., LTD.**
**1-5, Edamitsu-2-chome Yahatahigashi-ku**
**Kitakyushi-shi Fukuoka 805(JP)**

(72) Inventor: **HARADA, Kosuke**
**4-6, Sakurazaka 2-chome Chuo-ku**
**Fukuoka-shi Fukuoka 810(JP)**
Inventor: **TAKEUCHI, Shinjiro Sanhaitsu**
**Edamitsu 4-503**
**9, Edamitsu 4-chome Yahata-higashi-ku**
**Kitakyushu-shi Fukuoka 805(JP)**

(74) Representative: **Boon, Graham Anthony et al**
**Elkington and Fife Prospect House 8 Pembroke Road**
**Sevenoaks, Kent TN13 1XR(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

This invention relates to an apparatus for detecting magnetism through a self-exciting operation of a magnetic semiconductor coupled circuit constituted by a non-linear magnetic resonant circuit and an operational amplifier.

In the prior art, flux gates using ring-like or rod-like cores are typically employed for measuring weak magnetic fields. Among such flux gates are those of external excitation type using a separate AC exciting power source circuit and having a maximum sensitivity as high as several $10^{-5}$ to several $10^{-6}$ gauss.

The basic construction of this apparatus comprises a magnetic sensor section including a ring-like or rod-like cores as a magnetic sensor element, a driver section including an AC exciting power source for exciting the cores at an exciting frequency f of several kHz to several 10 kHz, a synchronous rectifier section for amplifying and detecting an output component at the double frequency 2f of the core excitation power, a double frequency section for producing a reference signal of the double frequency component at 2f from the exciting frequency f and feeding it to the synchronous rectifier section, and a display circuit section for displaying the intensity and polarity of the magnetic field.

However, in order to permit high sensitivity measurement of a magnetic field in a very small space with this system, the core shape must be made as small as possible. With a small core, the detected double frequency component (at 2f) is very small, and the signal-to-noise ratio is very inferior, so that it is difficult to obtain high sensitivity measurement of a magnetic field.

In order to solve this problem, methods have been proposed which are described in Japanese Patent Publication No. 54-6856 and Japanese Patent Publication No. 54-16232, in which the exciting frequency is increased, e.g., an exciting frequency of several MHz is adopted, while a capacitor is inserted in a sensor circuit, whereby resonance or oscillation of the double frequency component at 2f is caused to increase the output voltage amplitude of the sensor circuit before being fed to a resonant amplifier, the output thereof being fed to the synchronous rectifier section.

These means, however, are based on excitation by a high frequency driving current. Therefore, the attenuation and waveform distortion in the transmission line are serious, and the signal-to-noise ratio is inferior. For these reasons, the cable connecting the magnetic sensor section and driver section should be as short as several meters at the most. Particularly, high sensitivity measurement of magnetism is impossible in such a case as when the driver section and the magnetic sensor section installed in small spaces have to be spaced apart by several tens to several hundred metres.

An object of the invention, accordingly, is to provide a magnetism detecting apparatus of self-exciting type, which can be used even under the condition noted above.

US-A-4300095 discloses a magnetic field sensing device in which the average offset about zero caused to a triangular voltage waveform by an external magnetic field acting on a core is detected and integrated. The integrated value obtained is said to be proportional to the component of the external magnetic field that is in the direction of the sensor.

According to one aspect of the present invention there is provided an apparatus for detecting magnetism comprising:

a core;

an operational amplifier having a non-inversion input terminal, an inversion input terminal and an output terminal for amplifying a voltage between those input terminals to a saturation voltage having a character of positive or negative polarity;

an inductance element composed of a coil wound around said core and having a terminal connected to an earth terminal connected to ground and another terminal connected to said non-inversion input terminal of the operational amplifier;

a first resistance connected to said another terminal of the inductance element and said output terminal of the operational amplifier;

a second resistance connected to said inversion input terminal of the operational amplifier and a terminal of said first resistance on the side of the output terminal of the operational amplifier;

a third resistance connected to said earth terminal and a terminal of said second resistance of the side of the inversion input terminal of the operational amplifier;

wherein said inductance element is a non-linear inductance element, a bridge circuit is composed of said non-linear inductance element and said first, second and third resistances, and in that said operational amplifier acts as a sign discriminator for checking whether an input voltage between said two input terminals is positive or negative, providing a corresponding positive or negative saturation voltage, and switching automatically said saturation voltage, said bridge circuit having the core self-excited by the process of changing impedance of said non-linear inductance element by changing a flux density of the core starting from a value determined by a field detected, inputting to said operational amplifier a voltage resulting from the change of impedance between said another terminal of the non-linear inductance element and a terminal of the third resistance on the side of said inversion input terminal of the operational amplifier; changing in said operational amplifier, a strength of the field detected to a ratio between positive and negative level exciting periods of a rectangular-waveform saturation voltage of said operational amplifier and applying those saturation voltages to said core through the first resistance.

A magnetic sensor element used in accordance with the invention is a non-linear inductance element including one or two coils wound on the core. Functionally, a voltage as input signal at this non-linear inductance element has an important role of determining the timing of switching the polarities of a saturation output voltage of the operational amplifier.

Further, the current supplied from a driver section to a magnetic sensor section is transmitted as DC, the magnetic sensor section itself, which includes a magnetic thin layer core and an operational amplifier, constitutes a self-exciting circuit of magnetic semiconductor coupling type, the output signal of the magnetic sensor section is a rectangular AC signal with the ratio between positive and negative level periods thereof varying according to an applied magnetic field, and a DC signal obtained by integrating the rectangular AC signal is made a subject signal for magnetism detection, whereby a DC-DC transmission system is realized, which permits the magnetism detection signal to be obtained even where the magnetic sensor section and driver section are spaced apart by several tens to several hundred metres.

According to a preferred embodiment of the invention, an amorphous material is used for the magnetic core in the magnetic sensor section, thus constituting a very stable magnetic sensor type self-exciting circuit as magnetic semiconductor coupling circuit. Thus, the high frequency AC exciting power source and AC amplitude stabilizer section are made unnecessary. Also, there is no need at all for counter-measures against the attenuation of the AC exciting current and signal voltage on transmission lines.

Yet further, with the invention a signal processing function of detecting the applied direction and intensity of a measured field into corresponding polarity and level of an output voltage is achieved without use of any phase detector or amplitude detector but by the magnetic sensor section itself.

According to an embodiment of the present invention, the magnetic sensor section is driven from two i.e. positive and negative DC stabilized power sources to permit use of common power source for and common grounding of the magnetic sensor section and signal processing circuit.

Further, the magnetic sensor section consumes very low power so that it can be implemented on a printed circuit board of a linear IC level. Thus, a magnetic sensor system having high utility and versatility can be obtained. That is, the current for exciting the core may be 10 mA or below and can be sufficiently provided as operational amplifier output, and such a circuit as for amplifying the exciting current through an external power transistor is not required at all.

The invention will now be described in detail in conjunction with a preferred embodiment thereof with reference to the accompanying drawings, in which:

Fig. 1 is a view for explaining a basic construction of a magnetic sensor element of an embodiment according to the invention;

Fig. 2 is a circuit diagram showing what is obtained by adding a variable resistor to the circuit A of magnetic sensor element shown in Fig. 1;

Figs. 3(a) to 3(c) are views for explaining the operational principles of the invention using a B-H characteristic of a core representing a non-linear characteristic;

Figs. 4(a) to 4(c) are views showing waveforms of voltage $e_0$ appearing at an output terminal of the circuit of Fig. 3 when operation is started with

$Hex = 0$, $H'ex > 0$ and $H''ex < 0$;

Fig. 5 is a circuit diagram showing a circuit comprising a magnetic sensor section for automatically switching DC voltages for exciting a core, a driver section including a two-polarity driving DC power source and a display circuit section for integrating and amplifying the output of the magnetic sensor section;

Fig. 6 is a circuit diagram showing a circuit according to an embodiment of the invention for automatically performing the operational principles according to the invention; and

Fig. 7 is a view showing a current sensor.

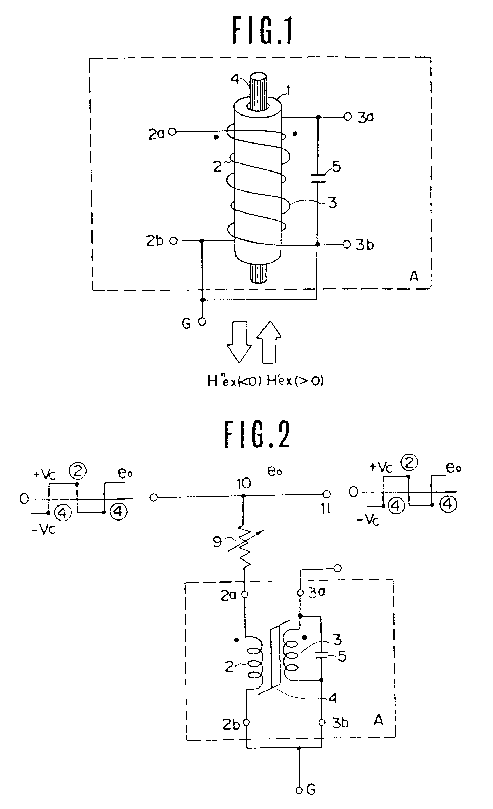

Referring to Fig. 1, reference numeral 1 designates a glass tube, on which are wound a primary coil 2 with terminals 2a and 2b and a secondary coil 3 with terminals 3a and 3b. A capacitor 5 is connected between coil terminals 3a and 3b. The terminals 2b and 3b are connected to ground G. The coils 2 and 3 have like polarity of winding as shown. An amorphous magnetic core 4 (hereinafter referred to as core) is inserted through a central space of the glass tube 1. The core is more suitably made of an amorphous magnetic material, which has a high magnetic permeability and a low coercive force. However, it may be made of other materials, e.g., it may be a thin Permalloy wire, a wire with a magnetic thin film coating (i.e., a magnetic plated wire), a silicon steel, a pure iron, ferrite, etc.

Fig. 2 shows a magnetic sensor element, which has the construction as described above, along with a variable resistor 9 which is provided for impedance adjustment for adjusting the waveform of an exciting voltage applied to the element.

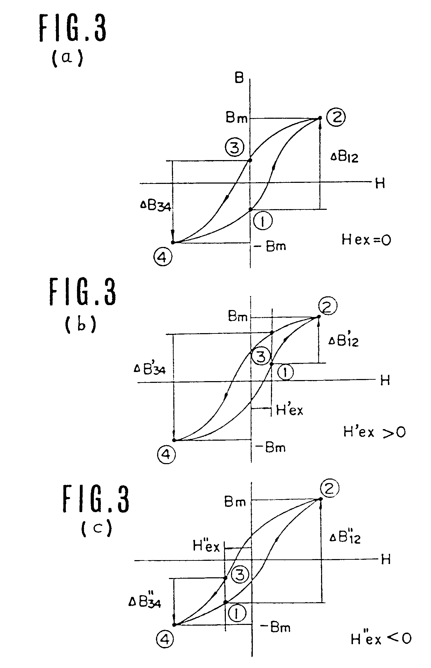

Figs. 3(a) to 3(c) are for explaining the operational principles of the invention using the B-H characteristic of the core 4 representing a non-linear characteristic. Shown in Fig. 3(a) is the B-H characteristic of the core 4 when there is no measured field Hex (i.e., Hex = 0). The core 4 has a hysteresis in its excitation cycle, which takes place along the illustrated path through points ① to ④ and back to point ① . When the core 4 in a state of Hex = 0 is excited up to the maximum flux density Bm by a positive exciting field produced by applying a positive DC voltage across the primary coil 2, there occurs a flux density change $\Delta B12$ as shown. When the DC voltage is reduced to zero as soon as the flux density of the core 4 reaches Bm, the magnetic field applied to the core 4 vanishes, so that the flux density quickly returns from the level of point ② to the level of point ③. When the core 4 is substantially excited to the negative maximum flux density -Bm by a negative exciting field produced by applying a negative DC voltage, the flux density change this time is $\Delta B34$. In this case, there holds a relation

$$|\Delta B12| = |\Delta B34|.$$

A case will now be considered, in which the excitation cycle is execured from a state with a positive measured field H'ex (>0) applied to the core 4, as shown in Fig. 3(b) illustrating a state of change of a flux density of the core starting from a value ① determined by measured field H'ex. In this case, the flux density change at the time of application of positive exciting field is $\Delta B'12$, and that at the time of application of negative exciting field is $\Delta B'34$. Obviously, there holds in this case a relation $|\Delta B'12| < |\Delta B'34|$ between $\Delta B'12$ and $\Delta B'34$. In other words, there holds a relation t' + < t'- between positive and negative exciting periods t' + and t'- required to excite the core 4 from the zero exciting DC voltage state to the positive and negative maximum flux density level, respectively.

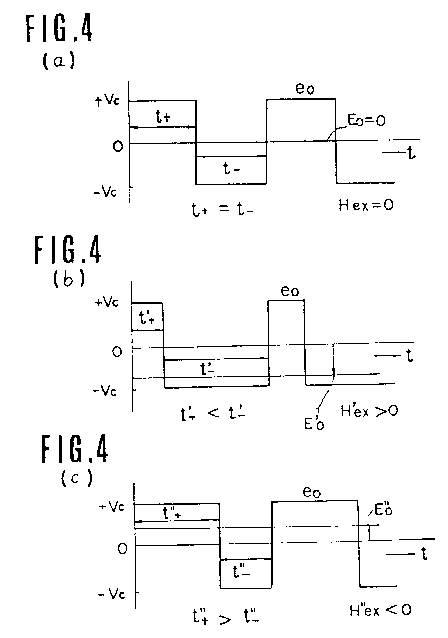

In case of executing the excitation cycle from a state with a negative measured field H''ex (<0) applied to the core 4, the flux density change is $\Delta B''12$ at the time of the positive excitation and $\Delta B''34$ at the time of the negative excitation, as shown in Fig. 3(c). As is seen, there holds a relation t'' + > t''- between the positive and negative exciting periods t'' + and t''-. Fig. 2 shows a magnetic sensor circuit, in which a variable resistor 9 is connected in series with the primary coil 2 for controlling the impedance with the variable resistor in order to prevent the exciting DC voltage applied to the core 4 in the excitation cycle noted above from being lowered or varied even at the maximum flux density level of the core 4. In case where the DC voltage polarities + Vc and -Vc are switched automatically upon reaching of the maximum flux density level at point ② or ④ of the core 4, the voltage $e_0$ at a terminal 10 will be observed to have a rectangular waveform having both positive and negative polarities. Fig. 4 shows the voltage waveform at the terminal 10 obtained under the assumption noted above in cases when Hex = 0, H'ex > 0 and H''ex < 0. It is to be noted that the positive level periods t +, t' + and t'' + and negative level periods t-, t' - and t''- of these two-polarity rectangular waves are controlled by the measured field Hex and H'ex and H''ex. This means that it is possible to effect a measurement of a magnetic field, in which the polarity and intensity of the measured field Hex are respectively expressed in terms of the sign and level of the integral of the rectangular voltage.

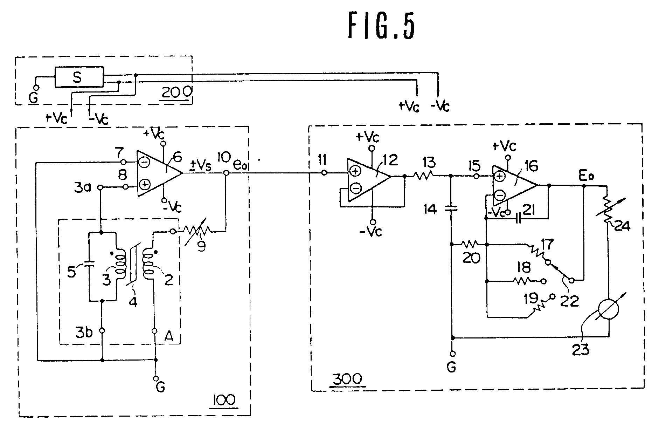

Operational principles underlying the invention will now be described with reference to Fig. 5 which shows a circuit comprising a magnetic sensor section 100 for automatically switching DC voltages for exciting the core 4, a driver section 200 including a driving DC power source S and a display section 300 for integrating and amplifying the output of the magnetic sensor section 100.

The magnetic sensor section 100 will now be described. It includes an operational amplifier 6, which has an inversion input terminal 7 connected to ground G and a non-inversion input terminal 8 connected to a terminal 3a of the secondary coil 3. The terminal 3b is connected to ground G. Capacitor 5 is connected across the secondary coil 3, and serves to absorb a noise component generated from the core 4. In view of the circuit construction, it constitutes a resonant circuit with respect to the secondary coil 3 and contributes to the stabilization of the timing of switching of DC voltages. Variable resistor 9 is connected to the output terminal of the operational amplifier 6. This resistor is provided for adjusting the voltage waveform at the output terminal 10, i.e., adjusting the load impedance inclusive of the variable resistor 9 and primary coil 2 to make the voltage waveform appearing at the output terminal as rectangular as possible.

The principles of self-excitation will now be described. When the operational amplifier 6 is positively saturated so that a saturation voltage Vs (>0) prevails at the terminal 10, the exciting current for exciting the core 4 flows through the resistor 9 and primary coil 2 to ground G. At this time, a voltage is induced across the secondary coil 3 through the core 4. The polarity of the induced voltage is positive on the side of the terminal 3a, so that a positive voltage is fed to the non-inversion terminal 8 of the operational amplifier 6. In consequence, the operational amplifier 6 continues to provide the positive saturation voltage output Vs. During this time, the core 4 continues to be excited. As the maximum flux density Bm is eventually reached, the magnetic permeability of core 4 is gradually reduced to reduce the induced voltage, thus extremely reducing the coil impedance of the secondary coil 3. At this time, the capacitor 5, which has been charged by the induced voltage, is discharged. Since the capacitor 5 constitutes a non-linear magnetic resonant circuit along with the secondary coil 3 as a non-linear inductance element, after it has been discharged, it is changed back to the opposite polarity due to the phenomenon of resonance. Therefore, the voltage on the side of the terminal 3a of the secondary coil 3, which has been positive, is charged to be negative, so that a negative voltage signal is fed to the non-inversion input terminal 8 of the operational amplifier 6. Thus, the output voltage $e_0$ at the output terminal 10 is automatically switched over to a negative DC saturation voltage -Vs. Immediately thereafter, the flux density level of the core 4 is quickly returned to a level determined by the measured field Hex. The flux density of the core is substantially varied toward the negative maximum flux density level -Bm by the negative saturation voltage -Vs. At this time, the impedance of the secondary coil 3 as the non-linear inductance element has been increased. Thus, the output voltage $e_0$ of the operational amplifier 6 is held at $-V_s$, and the capacitor 5 is charged by the induced voltage. When the negative maximum flux density level -Bm of the core 4 is reached, an inverted polarity input voltage signal (> 0) is fed to the non-inverson terminal 8 of the operational amplifier 6 owing to the resonance phenomenon of the non-linear magnetic resonant circuit, and the output terminal voltage $e_0$ is switched over to the positive DC saturation voltage Vs.

It is to be noted that the driving DC voltages Vc applied to the operational amplifier 6 are influenced by the voltage signal induced in the secondary coil wound on the core 4 such that the saturation voltages ±Vs appear alternately at the output terminal 10 of the operational amplifier 6 and the ratio between the positive and negative level periods (i.e., duty ratio) of the saturation voltage waveform (i.e., output voltage waveform) having opposite polarities is controlled by the measured field Hex.

The function of the capacitor 5 can be substituted for by the floating capacitance between adjacent turns of the coil wound on the core 4 by appropriately selecting the diameter and turns number of one coil. In this case, the capacitor 5 may obviously be dispensed with. In the display section 300 shown in Fig. 5, the rectangular output voltage $e_0$ is fed to a non-inversion input terminal 11 of a buffer 12. The output signal of the buffer 12 is coupled through an integrating circuit consisting of a resistor 13 and a capacitor 14 or a low-pass filter (not shown) to a non-inversion input terminal 15 of a gain control operational amplifier 16 for amplification. Resistors 17 and 20 are inserted between the output terminal and inversion input terminal of the operational amplifier 16 and ground terminal such that the amplification degree of the operational amplifier 16 can be selected according to the intensity of the measured field Hex. Reference numeral 21 designates a capacitor, which is inserted for the purpose of removing unnecessary AC noise component. Reference numeral 22 designates a selection switch for selecting an amplification degree. Reference numeral 23 designates a gauge which has a function of indicating the polarity and amplitude of current. Reference numeral 24 designates a variable resistor for controlling the level of current flowing into the gauge 23. The driver section 200 is a source of the positive and negative DC voltages Vc for the operational amplifier.

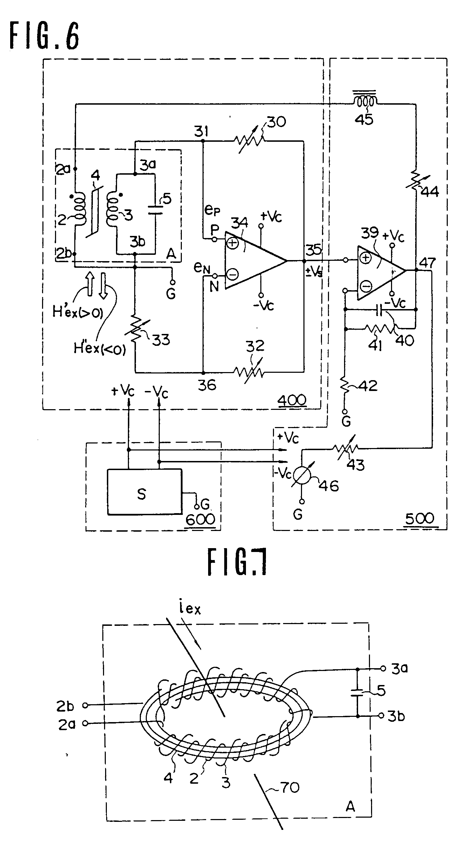

Fig. 6 shows a circuit according to an embodiment of the present invention which can automatically perform the operational principles of the invention as described above. Functionally, the circuit comprises a magnetic sensor section 400, a display section 500 and a DC stabilized power source section 600.

The magnetic sensor section 400 has a bridge circuit, which includes as its constituent elements variable resistor 30, secondary coil 3 and capacitor 5 in one side and variable resistors 32 and 33 in the other side. Each side of the bridge is connected at one end to an output terminal 35 of an operational amplifier 34 and at the other end to ground G. In this instance, the primary coil 2 in the magnetic sensor element A is used for a different purpose from that described before. More specifically, the primary coil 2 generates an exciting magnetic field enough to overcome the measured field Hex applied to the core 4.

The exciting field is generated as an exciting current which is supplied from the display section 500 to a terminal 2a.

This positive feedback system as shown in Fig. 6 has a purpose of stabilizing the circuit system of the magnetic sensor section, and improving the linearity of an input-output characteristic representing a relation between the measured field and output voltage, thus it is very useful in practice.

However, the primary coil 2 may be omitted without changing the object of the invention. In Fig.

6, coil 3 can fulfil the function of coil 2 because coil 2 is electromagnetically coupled to coil 3, and therefore it becomes possible to omit coil 2.

The operational amplifier 34 has a non-inversion input terminal P and an inversion input terminal N. A terminal 3a of the secondary coil 3 is connected to the terminal P via a connection point 31 and the variable resistors 32 and 33 are connected to the terminal N via a connection point 36. The operational amplifier 34 is not used as an amplifier for amplifying an input voltage difference $e_P$ - $e_N$ between the terminals P and N, but it functions as a sign discriminator for checking whether the input voltage difference $e_P$ - $e_N$ is positive or negative and providing a corresponding positive or negative saturation DC voltage. The capacitor 5, which absorbs a noise component generated from the core 4, also has a function of stabilizing the self-exciting operation by suppressing influence of sudden flux changes, e.g., a phenomenon of flux flyback that occurs with the switching of positive and negative voltages applied to the bridge, so that it is desirably inserted.

The self-exciting operation will now be described.

To facilitate understanding, a case will now be assumed in which the terminal voltages across the variable resistors 30, 32 and 33 of the bridge are V30, V32 and V33, the terminal voltage across the resonant circuit consisting of the secondary coil 3 is V3 and there holds an impedance relation R30 = R32. When the output voltage at the output terminal 35 of the operational amplifier 34 is switched over to the positive saturation DC voltage +Vs in this situation, the flux density level of the core 4 quickly returns to a level determined by the measured field (state 1 in Fig. 3 ). At this time, a positive voltage $e_N$ (>O) from the voltage divider consisting of the resistors 32 and 33 appear at the inversion input terminal N, while a positive voltage $e_P$ (>O) determined by the voltage divider consisting of the resistor 30 and non-linear magnetic resonant circuit appears at the non-inversion input terminal P. Since the core 4 is in an unsaturated flux state, the impedance $Z_2$ of the secondary coil is very high, and there holds a relation V3 > V33. The sign of the operational amplifier input voltage difference is thus positive ($e_P$ - $e_N$ > 0), so that the output voltage of the operational amplifier 34 is held at the positive saturation DC voltage +Vs. With subsequent gradual increase of flux density level of the core 4 toward the positive maximum flux density Bm, however, the Magnetic permeability is reduced to reduce the impedance $Z_2$ of the secondary coil 3 to become V3 immediately before the reaching of the positive maximum flux density Bm of the core 4. At this instant, the relation V3 > V33 is held. Immediately thereafter, however, the maximum flux density Bm of the core 4 is reached (state 2 in Fig. 3), so that now V3 < V33. As a consequence, the sign of the difference between the input voltages to the operational amplifier 34 is changed from positive sign ($e_P$ - $e_N$ > O) to negative sign ($e_P$ - $e_N$ < 0). The negative saturation DC voltage -Vs thus appears at the output terminal of the operational amplifier 34. This voltage is applied between the terminal 35 of the bridge and ground G, and at the same time the flux density level of the core 4 is quickly returned to the level determined by the measured field (state 3 in Fig. 3). After this negative part of excitation cycle has set in, the flux density of the core 4 continues to be changed in the negative direction. With a lapse of time the negative maximum flux density level -Bm of the core 4 is eventually reached (state 4 in Fig. 3) to satisfy the relation V3 > V33. Thus, the sign of the difference between the input voltages to the operational amplifier 34 becomes positive ($e_P$ - $e_N$ > 0), and the positive saturation DC voltage +Vs appears again at the output terminal 35.

As has been shown, the saturation DC voltages ±Vs of the operational amplifier 34 are automatically switched whenever the maximum flux density levels ±Bm of the core are reached.

Also, it will be readily understood that the rectangular voltage waveforms as shown in Fig. 4 can be observed at the output terminal of the operational amplifier 34 when the operation as described above is started from the states with the measured fields Hex, H'ex (> O) and H''ex (< O) applied to the core 4. For the sake of exactness ±Vc shown in Fig. 4 may be replaced with ±Vs.

The display section 500 includes an operational amplifier 39 for integrating and amplifying the output voltage of the magnetic sensor section 400, an integrating capacitor 40 connected thereto, resistors 41, 42, 43 and 44, a choke coil 45 and a gauge 46.

At an output terminal 47 of the operational amplifier 39 is observed a positive or negative DC voltage corresponding to the N or S pole and intensity of the magnetic field.

The choke coil 45 is inserted for the purposes of preventing a noise component from the magnetic sensor section 400 from having adverse effects on the display circuit section when a current is caused in a direction of cancelling the measured field applied to the core 4 and also of blocking an induced current due to an induced voltage in the secondary coil to thereby ensure stabilized self-exciting operation. It may be replaced with a resistor. The DC stabilized power source section serves to drive the operational amplifiers 34 and 39. According to the invention, according to which only DC component is transmitted between the magnetic sensor section 400 and display section 500, it is only the DC component that is transmitted between the magnetic sensor section 400 and stabilized DC power source section 600, that is, power and signal are transmitted by a perfect DC-DC system. Therefore, it is possible to install the DC stabilized power source section 600 and display section 500 in a measuring chamber and monitor in the measured chamber changes of a magnetic field or abnormal variations of the earth magnetism sensed by the magnetic sensor section 400 which is spaced apart from the measuring chamber by several 100m.

Fig. 7 shows an example of current sensor, which uses a ring-like core 4 forming a closed magnetic path. In this instance, a magnetic sensor element of closed magnetic path type is constituted by a coil with an insulating coating, which is wound on a ring-like magnetic core 4, and current iex that penetrates the ring-like core 4 is controlled by high sensitivity control. The principles of detection in this instance will be readily understood by substituting Hex noted above for the magnetic field produced by iex.

Claim 4 sets out a particular embodiment of the invention.

As has been described in the foregoing, according to the invention it is possible to provide a method of sensing magnetism based on a magnetic semiconductor coupling system capable of being implemented on an IC substrate, which has promising performance and utility in the technology.

The apparatus according to the invention, as described above, is a magnetism detecting apparatus of self-exciting type, which is useful as an apparatus for high sensitivity measurement of a magnetic field in a small space.

**Claims**

1. An apparatus for detecting magnetism comprising:
    a core (4);
    an operational amplifier (34) having a non-inversion input terminal, an inversion input terminal and an output terminal for amplifying a voltage between those input terminals to a saturation voltage having a character of positive or negative polarity;
    an inductance element composed of a coil (3) wound around said core and having a terminal connected to an earth terminal (3b) connected to ground (G) and another terminal (3a) connected to said non-inversion input terminal of the operational amplifier;
    a first resistance (30) connected to said another terminal (3a) of the inductance element and said output terminal of the operational amplifier;
    a second resistance (32) connected to said inversion input terminal of the operational amplifier and a terminal of said first resistance on the side of the output terminal of the operational amplifier;
    a third resistance (33) connected to said earth terminal and a terminal of said second resistance of the side of the inversion input terminal of the operational amplifier;
    wherein said inductance element is a non-linear inductance element, a bridge circuit is composed of said non-linear inductance element and said first, second and third resistances, and in that said operational amplifier acts as a sign discriminator for checking whether an input voltage between said two input terminals is positive or negative, providing a corresponding positive or negative saturation voltage, and switching automatically said saturation voltage, said bridge circuit having the core self-excited by the process of changing impedance of said non-linear inductance element by changing a flux density of the core starting from a value determined by a field detected, inputting to said operational amplifier a voltage resulting from the change of impedance between said another terminal of the non-linear inductance element and a terminal of the third resistance on the side of said inversion input terminal of the operational amplifier; changing in said operational amplifier, a strength of the field detected to a ratio between positive and negative level exciting periods of a rectangular-waveform saturation voltage of said operational amplifier and applying those saturation voltages to said core through the first resistance (30).

2. An apparatus for detecting magnetism as claimed in claim 1, which further comprises an indication circuit connected in series with said output terminal of the operational amplifier, which indication circuit integrates an output voltage of the operational amplifier to detect the ratio of the positive and negative level exciting periods changed respectively in the operational amplifier.

3. An apparatus for detecting magnetism as claimed in claim 2, which comprises a further coil (2) wound around said core (4) separately from said coil (3), and having a terminal connected to said earth terminal and another terminal connected to an output terminal of the indication circuit.

4. An apparatus for detecting magnetism as claimed in claim 3, wherein said core (4) and the coils (3,2) wound on said core each consist of two divisions, and said coil divisions are differentially connected to one another.

5. An apparatus for detecting magnetism as claimed in any preceding claim, wherein a capacitance (5) is provided across the terminals of the non-linear inductance element (3) to form a resonant circuit.

6. An apparatus for detecting magnetism as claimed in any preceding claim, wherein said core is a ring-like core.

**Patentansprüche**

1. Vorrichtung zum Feststellen von Magnetismus, enthaltend: einen Kern (4);
einen Operationsverstärker (34) mit einem nichtinvertierenden Eingangsanschluß, einem invertierenden Eingangsanschluß und einem Ausgangsanschluß zur Verstärkung einer Spannung zwischen diesen Eingangsanschlüssen auf eine Sättigungsspannung mit einem Charakter positiver oder negativer Polarität;
ein Induktivitätselement, das von einer um den Kern gewickelten Spule (3) besteht, die einen mit einem mit Masse (G) verbundenen Masseanschluß (3b) verbundenen Anschluß und einen weiteren mit dem nichtinvertierenden Eingangsanschluß des Operationsverstärkers verbundenen Anschluß (3a) aufweist;
einen ersten, mit dem anderen Anschluß (3a) des Induktivitätselementes und dem Ausgangsanschluß des Operationsverstärkers verbundenen Widerstand (30);
einen mit dem invertierenden Eingangsanschluß des Operationsverstärkers und einem Anschluß des ersten Widerstandes auf der Seite des Ausgangsanschlusses des Operationsverstärkers verbundenen zweiten Widerstand (32);
einen mit dem Masseanschluß und einem Anschluß des zweiten Widerstandes auf der Seite des invertierenden Eingangsanschlusses des Operationsverstärkers verbundenen dritten Widerstand (33);
wobei das Induktivitätselement ein nichtlineares Induktivitätselement ist, eine Brückenschaltung aus dem nichtlinearen Induktivitätselement und dem ersten, zweiten und dritten Widerstand gebildet ist, und wobei der Operationsverstärker als ein Vorzeichen-Diskriminator zur Überprüfung, ob eine Eingangsspannung zwischen den beiden Eingangsanschlüssen positiv oder negativ ist, zur Lieferung einer entsprechenden positiven oder negativen Sättigungsspannung und zum automatischen Schalten der Sättigungsspannung wirkt, wobei der Kern der Brückenschaltung durch den Vorgang des Änderns der Impedanz des nichtlinearen Induktivitätselementes durch Ändern einer Flußdichte des Kerns, ausgehend von einem von einem festgestellten Feld bestimmten Wert, des Eingebens einer sich aus der Änderung der Impedanz zwischen dem weiteren Anschluß des nichtlinearen Induktivitätselementes und einem Anschluß des dritten Widerstandes auf der Seite des invertierenden Eingangsanschlusses des Operationsverstärkers ergebenden Spannung in den Operationsverstärker, des Änderns einer Stärke des festgestellten Feldes in dem Operationsverstärker auf ein Verhältnis zwischen Erregungsperioden mit positiven und negativen Werten einer Sättigungsspannung des Operationsverstärkers mit Rechteck-Wellenform und des Anlegens dieser Sättigungsspannungen an den Kern durch den ersten Widerstand (30) selbst erregt wird.

2. Vorrichtung zum Feststellen von Magnetismus nach Anspruch 1, die weiterhin eine in Reihe mit dem Ausgangsanschluß des Operationsverstärkers verbundene Anzeigeschaltung enthält, die eine Ausgangsspannung des Operationsverstärkers zum Feststellen des Verhältnisses der in dem Operationsverstärkers geänderten Erregungsperioden mit positivem bzw. negativem Wert integriert.

3. Vorrichtung zum Feststellen von Magnetismus nach Anspruch 2, die eine getrennt von der Spule (3) um den Kern (4) gewickelte weitere Spule (2) enthält, die einen mit dem Masseanschluß verbundenen Anschluß und einen weiteren, mit einem Ausgangsanschluß der Anzeigeschaltung verbundenen Anschluß aufweist.

4. Vorrichtung zum Feststellen von Magnetismus nach Anspruch 3, bei der der Kern (4) und die auf den Kern gewickelten Spulen (3, 2) jeweils aus zwei Abteilungen bestehen und die Spulenabteilungen differentiell verbunden sind.

5. Vorrichtung zum Feststellen von Magnetismus nach einem vorhergehenden Anspruch, bei der eine Kapazität (5) über den Anschlüsse des nichtlinearen Induktivitätselementes (3) zur Bildung einer Resonanzschaltung vorgesehen ist.

6. Vorrichtung zum Feststellen von Magnetismus nach einem vorhergehenden Anspruch, bei dem der Kern ein ringartiger Kern ist.

**Revendications**

**1.** Appareil de détection de magnétisme comprenant :

un noyau (4) ;

un amplificateur opérationnel (34) ayant une borne d'entrée sans inversion, une borne d'entrée avec inversion et une borne de sortie et destiné à amplifier une tension entre ces bornes d'entrée jusqu'à une tension de saturation ayant un caractère de polarité positive ou négative ;

un élément d'induction se composant d'une bobine (3) enroulée autour dudit noyau et ayant une borne connectée à une borne de terre (3b)connectée à la masse (G) et une autre borne (3a) connectée à ladite borne d'entrée sans inversion de l'amplificateur opérationnel ;

une première résistance (30) connectée à ladite autre borne (3a) de l'élément d'induction et à ladite borne de sortie de l'amplificateur opérationnel ;

une seconde résistance (32) connectée à ladite borne d'entrée avec inversion de l'amplificateur opérationnel et à une borne de ladite première résistance se trouvant sur le côté de la borne de sortie de l'amplificateur opérationnel ;

une troisième résistance (33) connectée à ladite borne de terre et à une borne de ladite seconde résistance qui se trouve sur le côté de la borne d'entrée avec inversion de l'amplificateur opérationnel ;

appareil dans lequel ledit élément d'induction est un élément d'induction non-linéaire, un circuit en pont se compose dudit élément d'induction non-linéaire et desdites première, seconde et troisième résistances, et dans lequel ledit amplificateur opérationnel agit en discriminateur de signe pour contrôler si une tension d'entrée entre lesdites deux bornes d'entrée est positive ou négative, pour produire une tension de saturation correspondante positive ou négative et pour commuter automatiquement ladite tension de saturation, le noyau dudit circuit en pont étant auto-excité par le processus de changement d'impédance dudit élément d'induction non-linéaire par modification d'une densité de flux du noyau à partir d'une valeur déterminée par un champ détecté, par entrée dans ledit amplificateur opérationnel d'une tension résultant du changement d'impédance entre ladite autre borne de l'élément d'induction non-linéaire et une borne de la troisième résistance se trouvant sur le côté de ladite borne d'entrée avec inversion de l'amplificateur opérationnel ; par transformation dans ledit amplificateur opérationnel d'une force du champ détecté en un rapport entre les périodes d'excitation à un niveau positif et négatif d'une tension de saturation à onde rectangulaire dudit amplificateur opérationnel et application de ces tensions de saturation audit noyau par l'intermédiaire de la première résistance (30).

**2.** Appareil de détection de magnétisme selon la revendication 1, qui comprend par ailleurs un circuit d'indication monté en série avec ladite borne de sortie de l'amplificateur opérationnel, ledit circuit d'indication intégrant une tension de sortie de l'amplificateur opérationnel afin de détecter le rapport entre les périodes d'excitation de niveau positif et négatif ayant varié respectivement dans l'amplificateur opérationnel.

**3.** Appareil de détection de magnétisme selon la revendication 2, qui comprend une autre bobine (2) enroulée autour dudit noyau (4) séparément de ladite bobine (3) et ayant une borne connectée à ladite borne de terre et une autre borne connectée à une borne de sortie du circuit d'indication.

**4.** Appareil de détection de magnétisme selon la revendication 3, dans lequel ledit noyau (4) et les bobines (3,2) enroulées sur ledit noyau sont chacun formés de deux parties et lesdites parties de bobine sont connectées de manière différentielle l'une à l'autre.

**5.** Appareil de détection de magnétisme selon l'une quelconque des revendications précédentes, dans lequel un condensateur (5) est monté sur les bornes de l'élément d'induction non-linéaire de manière à former un circuit résonant.

**6.** Appareil de détection de magnétisme selon l'une quelconque des revendications précédentes, dans lequel ledit noyau est un noyau torique.

# FIG.1

$H''_{ex}(<0) \quad H'_{ex}(>0)$

# FIG.2

# FIG.3
## (a)

# FIG.3
## (b)

# FIG.3
## (c)

EP 0 155 324 B1

# FIG.4
## (a)

$t_+ = t_-$

$H ex = 0$

# FIG.4
## (b)

$t'_+ < t'_-$

$H'ex > 0$

# FIG.4
## (c)

$t''_+ > t''_-$

$H''ex < 0$

# FIG.5

# FIG.6

# FIG.7